(19) Europäisches Patentamt / European Patent Office / Office européen des brevets

(11) **EP 4 512 691 A1**

(12) **EUROPEAN PATENT APPLICATION**
published in accordance with Art. 153(4) EPC

(43) Date of publication:
26.02.2025 Bulletin 2025/09

(21) Application number: 23803336.9

(22) Date of filing: 14.04.2023

(51) International Patent Classification (IPC):
*B62D 1/06* (2006.01)          *B62D 6/00* (2006.01)
*H01H 36/00* (2006.01)

(52) Cooperative Patent Classification (CPC):
B62D 1/06; B62D 6/00; H01H 36/00

(86) International application number:
PCT/JP2023/015106

(87) International publication number:
WO 2023/218854 (16.11.2023 Gazette 2023/46)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 12.05.2022 JP 2022079037

(71) Applicant: Autoliv Development AB
44783 Vargarda (SE)

(72) Inventor: YAMAZAKI, Yuki
Yokohama-shi, Kanagawa 222-8580 (JP)

(74) Representative: Schön, Thilo
Patentanwaltskanzlei Thilo Schön
Grünstraße 1
75172 Pforzheim (DE)

(54) **GRIP SENSING DEVICE AND PROGRAM**

(57) Abstract: A hands-on detection device and the like is provided that can accurately detect hands-on of a steering wheel. The hands-on detection device, which performs hands-on detection of a steering wheel, includes an acquiring unit that acquires a capacitance value detected by a capacitance sensor provided on the steering wheel, and a generating unit that generates a threshold value for detecting hands-on detection of the steering wheel based on the capacitance value acquired by the acquiring unit and a parameter corresponding to a state related to the change in the capacitance value.

FIG. 4

EP 4 512 691 A1

## Description

### TECHNICAL FIELD

The present invention relates to a hands-on detection device and to a program.

### BACKGROUND ART

Conventionally, a technique for monitoring whether or not a driver is gripping the steering wheel by using a sensor provided on the steering wheel has been widely used. By comparing the detection value of the capacitance sensor with a prescribed threshold value, it is possible to determine whether or not the steering wheel is being gripped.

Patent document 1 discloses a steering wheel unit equipped with a correcting part that calculates an average detection value for a prescribed number of detection values of the capacitance sensor including the current value and corrects for error generated in comparison of the detected value with the contact determination threshold value in the case a human body is not in contact with the steering wheel and the average value is greater than a correction determination threshold. According to the steering wheel unit disclosed in Patent Document 1, even if a disturbance occurs, reduction in the accuracy of detecting contact/noncontact of a human body with the steering wheel can be suppressed.

### RELATED ART DOCUMENTS

#### Patent Documents

Patent Document 1: Japanese Unexamined Patent Application 2019-23012

## SUMMARY OF THE INVENTION

### PROBLEM TO BE SOLVED BY THE INVENTION

The detection value (capacitance value) detected by the capacitance sensor changes due to the influence of various disturbances such as the vehicle's interior environment, driving conditions, and external noise. The state of change in capacitance value varies depending on the type of disturbance. Therefore, processing for correcting the capacitance value is single characteristic and so is unable to follow changes in the capacitance value, or follows in situations where following should not occur; therefore, accurate detection may not be feasible. However, the conventional technology described in Patent Document 1 does not take such viewpoints into consideration, and the accuracy of hands-on detection is insufficient.

An object of the present disclosure is to provide a hands-on detection device and the like that can accurately detect hands-on of a steering wheel.

### MEANS FOR SOLVING THE PROBLEM

The hands-on detection device according to an aspect of the present disclosure performs hands-on detection of a steering wheel, and includes an acquiring unit that acquires a capacitance value detected by a capacitance sensor provided on the steering wheel, and a generating unit that generates a threshold value for detecting hands-on detection of the steering wheel based on the capacitance value acquired by the acquiring unit and a parameter corresponding to a state related to the change in the capacitance value.

A program according to an aspect of the present disclosure causes a computer that performs hands-on detection on a steering wheel to acquire a capacitance value detected by a capacitance sensor provided on the steering wheel and executes a process of generating a threshold value for performing hands-on detection of the steering wheel based on the acquired capacitance value and a parameter corresponding to a state related to a change in the capacitance value.

### EFFECT OF THE INVENTION

According to the present disclosure, hands-on of the steering wheel can be detected with high accuracy.

### BRIEF DESCRIPTION OF THE DRAWINGS

FIG. 1 is a block diagram depicting an example configuration of a steering wheel device according to the present embodiment.

FIG. 2 is a front view of the steering wheel of the steering wheel device according to the present embodiment.

FIG. 3 is an explanatory diagram describing detection of capacitance value using a capacitance measuring circuit of the steering wheel device.

FIG. 4 is a functional block diagram depicting a configuration example of a control unit of a hands-on detection ECU.

FIG. 5 is a diagram depicting an example of a change in capacitance value.

FIG. 6A is a diagram depicting a method for setting a time constant T1 in a first parameter.

FIG. 6B is a diagram depicting a method for setting a time constant T1 in a first parameter.

FIG. 7A is a diagram depicting a method for setting a time constant T3 in a third parameter.

FIG. 7B is a diagram depicting a method for setting a time constant T3 in a third parameter.

FIG. 8 is a diagram describing hands-on detection using a third parameter.

FIG. 9 is a flowchart depicting an example of a processing procedure executed by a hands-on detection ECU.

FIG. 10 is a flowchart depicting an example of a detailed procedure for selecting a parameter.

FIG. 11 is a diagram depicting an example of hands-on determination when the time constant T1 is changed.

FIG. 12 is a diagram depicting an example of hands-on determination when the time constant T1 is changed.

FIG. 13 is a diagram depicting an example of hands-on determination when the time constant T1 is changed.

FIG. 14 is a diagram depicting an example of hands-on determination when the time constant T1 is changed.

FIG. 15 is a diagram depicting an example of hands-on determination when the time constant T2 is changed.

FIG. 16 is a diagram depicting an example of hands-on determination when the time constant T2 is changed.

FIG. 17 is a diagram depicting an example of hands-on determination when the time constant T2 is changed.

FIG. 18 is a diagram depicting an example of hands-on determination when the time constant T2 is changed.

FIG. 19 is a diagram depicting an example of hands-on determination using a time constant T3.

FIG. 20 is a diagram depicting another example of hands-on determination using a time constant T3.

## DESCRIPTION OF THE PREFERRED EMBODIMENTS

The present disclosure will be specifically described with reference to the drawings indicating embodiments thereof.

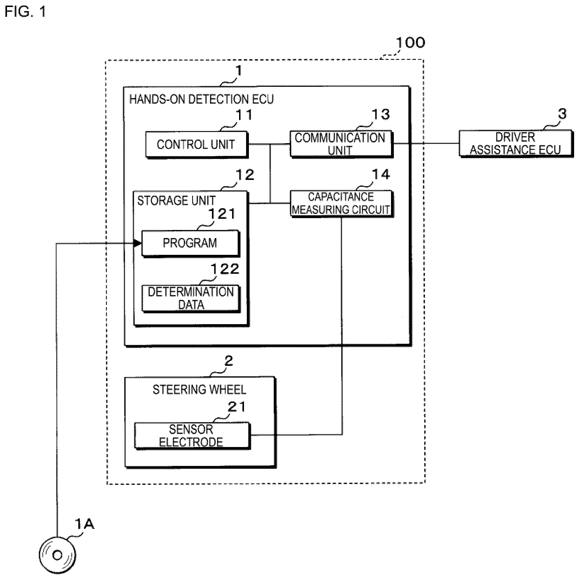

FIG. 1 is a block diagram depicting an example configuration of a steering wheel device 100 according to the present embodiment. The steering wheel device 100 includes a hands-on detection ECU (Electronic Control Unit) 1 and a steering wheel 2. The hands-on detection ECU 1 corresponds to the hands-on detection device. The hands-on detection ECU 1 is communicatively connected to on-board equipment such as, for example, a driver assistance ECU 3 by an in-vehicle network installed in the vehicle.

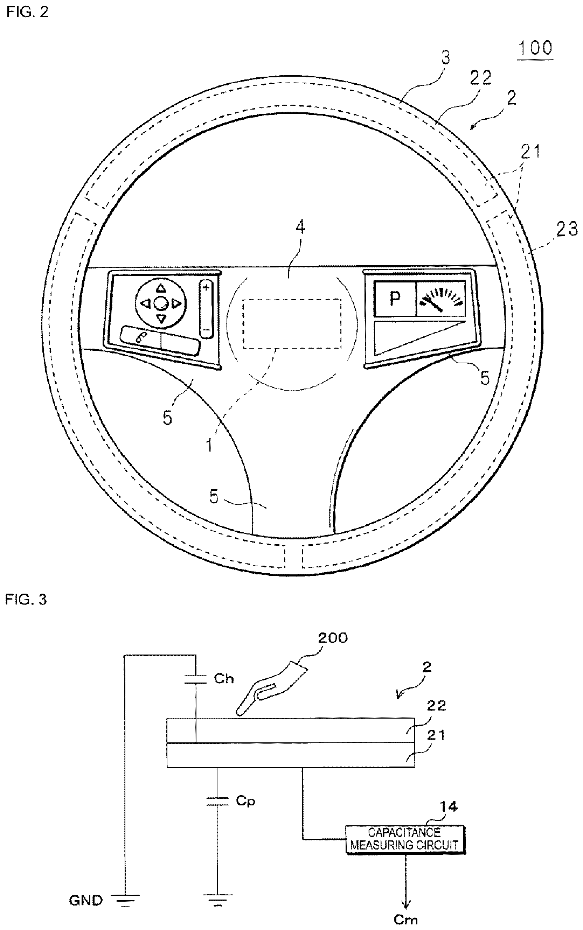

FIG. 2 is a front view of the steering wheel 2 of the steering wheel device 100 according to the present embodiment. The steering wheel 2 is equipped with a capacitance sensor (sensor electrode) 21. The sensor electrode 21 forms a capacitor between with the steering wheel 2 and/or a human body in contact with the steering wheel 2, and detects the magnitude of electrostatic capacitance (capacitance value) that changes depending on whether the human body is in contact with or not in contact with the steering wheel 2.

The hands-on detection ECU 1 performs hands-on detection based on the capacitance value detected by the sensor electrode 21. Specifically, the hands-on detection ECU 1 determines whether the steering wheel 2 is in a hands-on state or a hands-off state (hereinafter referred to as hands-on determination) by comparing the above-mentioned capacitance value with a prescribed threshold value. Here, the hands-on state means a state in which the driver grips the steering wheel 2, and the hands-off state means a state in which the driver is not gripping and has hands separated from the steering wheel 2.

As depicted in FIG. 2, the steering wheel 2 includes a circular shaped rim part 3 and a hub part 4 arranged in the center of the rim part 3. The hub part 4 has, for example, an airbag (not depicted) installed therein. The hub part 4 is connected to the rim part 3 by means of three spoke parts 5.

The rim part 3 is covered with a covering layer 22 such as leather, and the hub part 4 and spoke parts 5 are covered with, for example, a resin material. The sensor electrode 21 is provided inside of the rim part 3 along the circumferential direction of the rim part 3. The sensor electrode 21 is divided into three equal parts in the circumferential direction and each part is embedded respectively in the rim part 3. Note that the number of sensor electrodes 21 is not limited to three and may be two or less or four or more. Furthermore, the rim part 3 is not limited to a circular ring shape, but may be a non-circular shape (for example, a D-shape or a C-shape).

As depicted in FIG. 1, the hands-on detection ECU 1 includes a control unit 11, a storage unit 12, a communication unit 13, and a capacitance measurement circuit 14.

The control unit 11 includes one or more processors using a central processing unit (CPU), a graphics processing unit (GPU), and the like. The control unit 11 uses an internal clock, counter, and the like to read and execute programs and data stored in the storage unit 12 or ROM (Read-Only Memory), and the like; and thereby performs various control processing and calculation processing.

The storage unit 12 includes a non-volatile memory element such as a flash memory or an EEPROM (Electrically Erasable Programmable Read Only-Memory). The storage unit 12 stores various programs and data to which the control unit 11 refers. In the present Embodiment, the storage unit 12 stores a program 121 for causing a computer to execute processing related to hands-on detection (hands-on determination), and determination data 122 as data necessary for executing this program 121.

The determination data 122 includes information such as a formula for generating a threshold value Cthr used in the hands-on determination described below, an offset value Coff, a plurality of parameters P, and a corresponding relationship or the like between the parameters P and the state related to changes in capacitance value. In the present Embodiment, as an example, the parameters P include a first parameter P1, a second parameter P2, and a third parameter P3.

The program (program product) stored in the storage unit 12 may be in a form recorded in a computer-readable manner on storing media. The storage unit 12 stores a program read from the storing media 1A by a read device (not depicted). The storing media 1A is, for example, a magnetic disk, an optical disk, a semiconductor memory, or the like. In addition, the program may be downloaded from an external server connected to a communication network (not depicted) and stored in the storage unit 12. The program 121 may be a single computer program or may be composed of a plurality of computer programs, and may be executed on a single computer or on a plurality of computers interconnected by a network.

The communication unit 13 is a communication interface for transmitting and receiving with other on-board devices via the in-vehicle network. The communication unit 13 is connected to a Local Area Network (LAN) provided in-vehicle and transmits and receives information with the driver assistance ECU 3 and the like. The communicating part 13 transmits the hands-on determination results based on the control unit 11 to the driver assistance ECU 3.

The driver assistance ECU 3 is an ECU for executing processing according to an advanced driver assistance system. The driver assistance ECU 3 receives a signal indicating grip determination results from the control unit 11 via the communicating part 13 and prescribed processing according to the advanced driver assistance system is executed based on these hands-on determination results. For example, if hands-on determination results of hands-off state of the steering wheel 2 are received from the control unit 11 during autonomous driving, the driver assistance ECU 3 terminates autonomous driving. Note that driver assistance ECU 3 processing is not limited to autonomous driving and may be lane keep assist, parking assist, or the like.

The capacitance measurement circuit 14 is connected to the sensor electrode 21 and is an electrical circuit for detecting capacitance coupled to the sensor electrode 21. The control unit 11 acquires the capacitance value detected by the sensor electrode 21 by means of the capacitance measuring circuit 14.

FIG. 3 is an explanatory diagram describing detection of capacitance value using a capacitance measuring circuit 14 of the steering wheel device 100. The sensor electrode 21 is provided so as to be covered by a covering layer 22 of the steering wheel 2, and is interposed between the covering layer 22 and a urethane layer covering a core metal (neither of which is depicted).

The capacitance measurement circuit 14 is connected to the sensor electrode 21 of the steering wheel 2. After the sensor electrode 21 is activated, the capacitance measurement circuit 14 detects the electrostatic capacitance between the sensor electrode 21 and GND (ground) at a prescribed interval.

As indicated in FIG. 3, the capacitance value Cm (electrostatic capacitance) detected by the capacitance measurement circuit 14 includes the electrostatic capacitance Ch of the driver's hand 200 which is coupled when the driver grips the steering wheel 2, and the parasitic capacitance Cp that arises based on the internal structure of the steering wheel 2. Normally, in the hands-off state, the detected capacitance value Cm is equivalent to the parasitic capacitance Cp. The parasitic capacitance Cp varies due to, for example, fluctuations in the interior environment of the vehicle, deterioration of the product over time, the driving state, external noise, and the like.

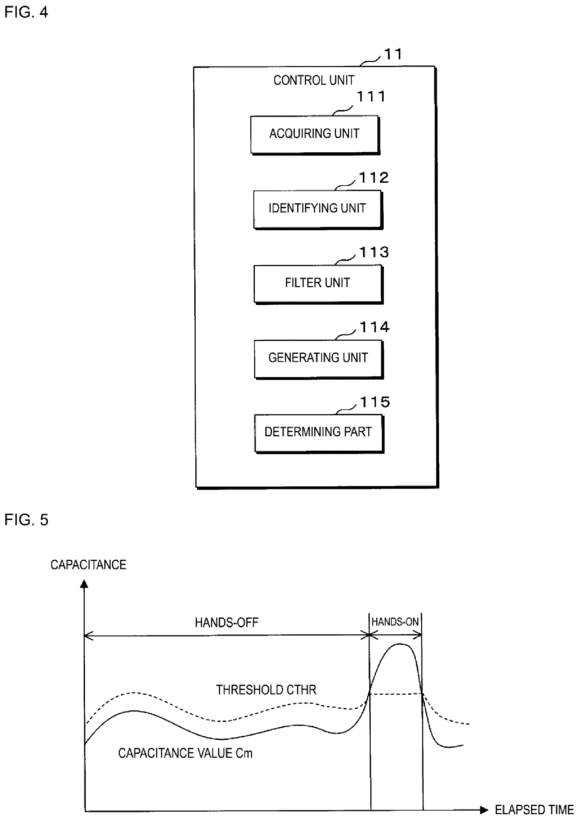

FIG. 4 is a functional block diagram depicting a configuration example of a control unit 11 of a hands-on detection ECU 1. The control unit 11 reads and executes a program 121 stored in the storage unit 12, thereby functioning as an acquiring unit 111, an identifying unit 112, a filter unit 113, a generating unit 114, and a determination unit 115.

The acquiring unit 111 acquires the capacitance value Cm output from the capacitance measurement circuit 14. The capacitance value Cm acquired by the acquiring unit 111 is output to each of the filter unit 113, the generating unit 114, and the determination unit 115.

The identifying unit 112 identifies a state related to a change in the capacitance value Cm based on the time-series data of the capacitance value Cm received from the acquiring unit 111 and the determination result of the hands-on state or hands-off state received from the determination unit 115. Furthermore, the identifying unit 112 specifies a parameter P to be used in a filter processing, which will be described below, from among the plurality of parameters P stored in the storage unit 12, based on the specified state related to the change in the capacitance value Cm. Specifically, one parameter P is selected from the first parameter P1, the second parameter P2, and the third parameter P3.

The state regarding the change in the capacitance value Cm is information for identifying a parameter P used in the filter processing described below, and is determined based on the change tendency of the capacitance value Cm. Specifically, the state regarding the change in the capacitance value Cm can be determined based on whether or not the initial hands-on detection is performed after the sensor electrode 21 is activated, and the tendency of the capacitance value Cm to increase or decrease. In the present Embodiment, as an example, the state regarding the change in the capacitance value Cm is segregated into a plurality of states, including four states, a first state to a fourth state. These operations will be described below in further detail. The identifying unit 112 classifies the current state into any one of the first state to the fourth state.

The parameter P has a time constant T that represents the response speed to a change in the capacitance value Cm. The time constant T differs for each of the parameters P. The first parameter P1 has a time constant T1 with the best response for following changes in the capacitance value Cm. The second parameter P2 has a time constant T2 that is larger than the first time constant T1 and follows the change in the capacitance value Cm with a longer delay time than the time constant T1. The third parameter P3 has a time constant T3 that is larger than the time constant T2 and follows the change in the capacitance value Cm with a longer delay time than the time constant T2.

The identifying unit 112 identifies the parameter P associated with the identified current state by referring to the corresponding relationship between the state related to the change in the capacitance value Cm and each parameter P that are stored in advance in the determination data 122. The identifying unit 112 outputs the specified parameter P to the filter unit 113.

The filter unit 113 performs a filter processing on the capacitance value Cm received from the acquiring unit 111 using the parameter P received from the identifying unit 112. The filter unit 113 functions as a low-pass filter that attenuates and blocks the capacitance value Cm corresponding to unnecessary noise. The value obtained by the filter processing is set as the corrected capacitance value Cm'. The corrected capacitance value Cm' obtained by the filter unit 113 is output to the generating unit 114.

The generating unit 114 generates a threshold value Cthr used for hands-on determination, based on the corrected capacitance value Cm' received from the filter unit 113. The threshold value Cthr can be a value obtained by adding the offset value Coff to the corrected capacitance value Cm'. The offset value Coff is a capacitance value that is set in advance as an offset, and is a fixed value. That is, the threshold value Cthr dynamically increases and decreases in response to changes in the capacitance value Cm. By using the capacitance value Cm to generate the threshold value Cthr, the threshold value Cthr can be set while taking into consideration increases and decreases in the capacitance value Cm in the hands-off state from environmental fluctuations and the like.

The offset value Coff can be set appropriately, for example, based on the touch conditions required for hands-on detection (for example, three-finger touch, four-finger touch, and the like) and a capacitance value corresponding to the noise in the steering wheel device 100 and the EMC resistance to the noise.

The generating unit 114 may generate the threshold value Cthr described above only in the case of a hands-off state based on the determination result of whether the state is hands-on state or hands-off state received from the determination unit 115, and may not generate the threshold value Cthr in the case of a hands-on state. In other words, in the hands-off state, the generating unit 114 updates the threshold value Cthr at any time, while from the time when the hands-off state switches to the hands-on state until the time when the state switches back to the hands-off state, the generating unit retains the previous threshold value Cthr and uses the value as-is, without updating the threshold value Cthr. The threshold value Cthr generated by the generating unit 114 is output to the determination unit 115.

The determination unit 115 performs hands-on determination based on the capacitance value Cm received from the acquiring unit 111 and the threshold value Cthr received from the generating unit 114.

FIG. 5 is a diagram depicting an example of a change in capacitance value Cm. The vertical axis of the graph depicted in FIG. 5 represents capacitance, and the horizontal axis represents elapsed time. In the graph, the solid line indicates the capacitance value Cm, and the dashed line indicates the threshold value Cthr. As depicted in FIG. 5, the capacitance value Cm for hands-on the steering wheel 2 is greater than the capacitance value Cm for hands-off the steering wheel 2.

The determination unit 115 determines the hands-on state when the capacitance value Cm is equal to or greater than the threshold value Cthr, and determines the hands-off state when the capacitance value Cm is less than the threshold value Cthr. The determination result by the determination unit 115 is output to the identifying unit 112 and the generating unit 114, and is also transmitted to the driver assistance ECU 3 via the communication unit 13.

The corresponding relationship between the state related to the change in capacitance value Cm and the parameter P, and the method of setting the time constant T for each parameter P will be described in detail below.

As described above, the states related to the change in the capacitance value Cm are classified into the first state to the fourth state. The first state and the second state correspond to a period from when the sensor electrode 21 is activated until initial hands-on of the steering wheel 2 of the driver is detected, and correspond to a start-up state. The third state and the fourth state are periods after the initial hands-on is detected and correspond to normal states.

The first state is a state in which the capacitance value Cm is constant or decreases during the period from when the sensor electrode 21 is activated until when the initial hands-on of the steering wheel 2 is detected. The second state is a state in which the capacitance value Cm increases during the period from when the sensor electrode 21 is activated until when the initial hands-on of the steering wheel 2 is detected. The third state is a state in which the capacitance value Cm is constant or increasing during the period after the initial hands-on is detected. The fourth state is a state in which the capacitance value Cm is decreasing during the period after the initial hands-on is detected.

When the state of the capacitance value Cm is the first state, the first parameter P1 having the smallest time constant T1 is used as the parameter P. Similarly, for the second state and third state, a second parameter P2 having a time constant T2 greater than the time constant T1 is used. In the case of the fourth state, a third parameter P3 is used having a time constant T3 which is even greater than the time constant T2.

After activation of the sensor electrode 21, the first parameter P1 is selected as an initial parameter. Then, the first parameter P1 is continuously used until the initial hands-on operation is detected. When the capacitance value Cm has a rising trend in the case where the first parameter P1 is selected, the parameter is switched to the second parameter P2. When the second parameter P2 is selected and the capacitance value Cm has a decreasing trend, the parameter is switched back to the first parameter P1.

In the case where the second parameter P2 is selected, when the state is determined to be the hands-on state (when initial hands-on is detected), the state transitions from the start state to the normal state. In a normal state, the second parameter P2 and the third parameter P3 are switched as needed in response to the increase/decrease tendency of the capacitance value Cm. When the capacitance value Cm has an increasing trend, the second parameter P2 is selected, and when the capacitance value Cm has a decreasing trend, the third parameter P3 is selected.

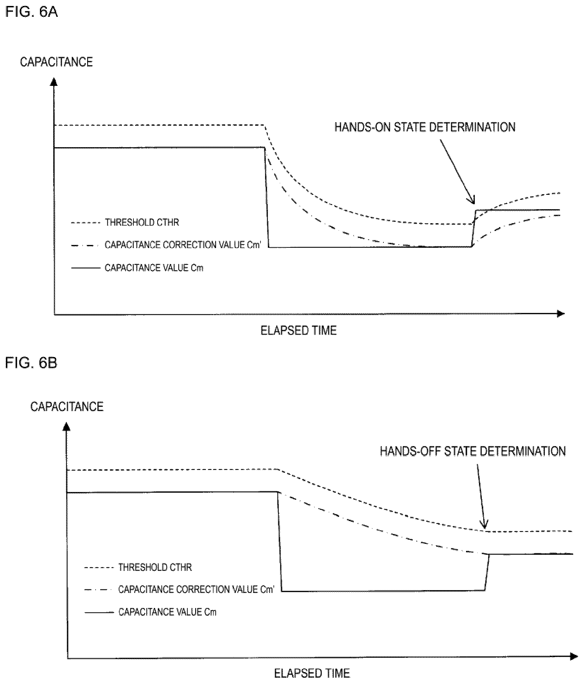

FIG. 6A and FIG. 6B are explanatory diagrams for a method of setting the time constant T1 for the first parameter P1. FIG. 6A is a graph depicting an example of a change in the threshold value Cthr when the time constant T1 is small, and FIG. 6B is a graph depicting an example of a change in the threshold value Cthr when the time constant T1 is large. In the graphs indicated in FIG. 6A and FIG. 6B, the vertical axis represents capacitance, and the horizontal axis represents elapsed time. In the graphs, the solid line indicates the capacitance value Cm, the centerline indicates the corrected capacitance value Cm', and the dashed line indicates the threshold value Cthr.

In order to perform hands-on determination in a normal state, the threshold value Cthr for the no hands state must be determined in advance. In order to start hands-on determination in the normal state if the driver is gripping the steering wheel 2 when the sensor electrode 21 is activated, the threshold value Cthr for the hands-off state must be determined and the initial hands-on must be detected. The calibration preferably only takes a short time. The first parameter P1 is a parameter to be used in this manner of initial state (at start-up).

The graphs in FIG. 6A and FIG. 6B depict the changes in capacitance value Cm, and the like when the steering wheel device 100 is activated while the driver is already gripping the steering wheel 2, then the driver releases the steering wheel 2 and grips the steering wheel again.

The capacitance value Cm decreases rapidly when the hand is removed and then increases rapidly when hands-on is performed again. By performing filter processing on the capacitance value Cm using a first parameter P1 including a time constant T1, the corrected capacitance value Cm' attenuates during the hands-off period.

As indicated in FIG. 6A, when the time constant T1 is set to a relatively small value, the attenuation of the corrected capacitance value Cm' becomes large. As the corrected capacitance value Cm' attenuates, the threshold value Cthr lowers significantly during the hands-off period. At the time when the object is gripped again, the capacitance value Cm becomes greater than the threshold value Cthr, and the hands-on determination result becomes "hands-on".

On the other hand, as depicted in FIG. 6B, when the time constant T1 is set to a relatively large value, the attenuation of the corrected capacitance value Cm' becomes small (gradual). As the corrected capacitance value Cm' attenuates, the threshold value Cthr lowers gradually during the hands-off period. At the time when the object is gripped again, the capacitance value Cm becomes smaller than the threshold value Cthr, and the hands-on determination result becomes "hands-off".

The time constant T1 may be set to an appropriate value so that the "hands-on state" can be correctly determined at the time when the object is gripped again, that is, so that the capacitance value Cm exceeds the threshold value Cthr when the object is gripped again. As an example, the time constant T1 can be calculated based on the minimum hands-off period required for hands-on detection, the capacitance value Cm for the gripping method assumed at activation, and the capacitance value Cm based on touch conditions required for hands-on detection.

By setting the value of the time constant T1 to a relatively large value, the decrease in the capacitance value Cm can be followed with good responsiveness. Therefore, the time until the threshold value Cthr is determined, and hands-on determination becomes possible can be shortened.

The second parameter P2 is a parameter for eliminating instantaneous increases in the capacitance value Cm that occur under normal conditions, while following gradual increases in the capacitance value Cm due to environmental changes such as temperature and humidity changes inside the vehicle.

The time constant T2 in the second parameter P2 is a value larger than the time constant T1 and may be set to an appropriate value so as to be able to reflect changes in the capacitance value Cm associated with changes in temperature and humidity inside the vehicle. The time constant T2 can be set to a value that is based on the rate of change in capacitance due to changes in temperature and humidity around the steering wheel 2, for example, and that corresponds to the rate of change with a prescribed margin.

By making the time constant T2 larger than the time constant T1, the changes in temperature and humidity inside the vehicle can be followed, while removing, by filter processing, instantaneous increases in the capacitance value Cm caused by noise. In other words, the change in the capacitance value Cm that should be picked up while removing unnecessary changes in the capacitance value Cm can be reflected, thereby preventing erroneous detection of a hands-on state and improving the reliability of the determination. Since the increase in capacitance value Cm based on gripping of the steering wheel 2 is steeper than the increase in capacitance value Cm due to environmental changes, hands-on detection can be reliably achieved even if time constant T2 is made larger than time constant T1.

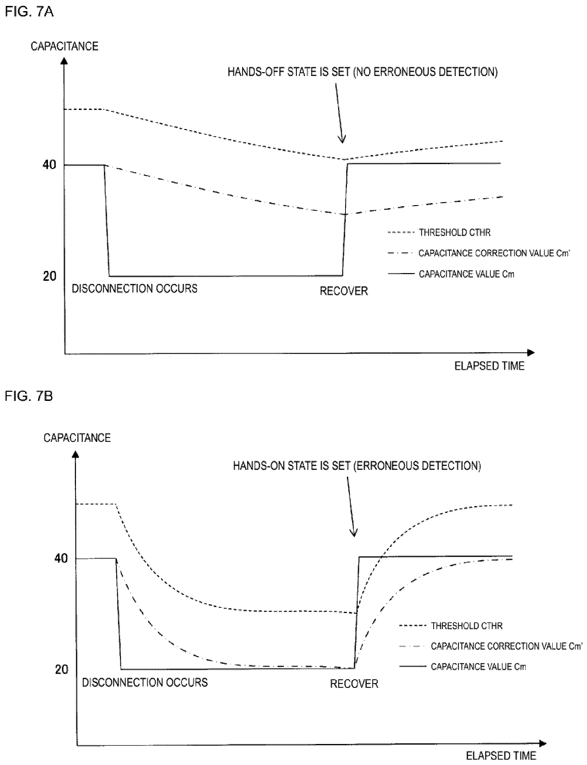

FIG. 7A and FIG. 7B are explanatory diagrams for a method of setting the time constant T3 for the third parameter P3. FIG. 7A is a graph depicting an example of a change in the threshold value Cthr when the time constant T1 is small, and FIG. 7B is a graph depicting an example of a change in the threshold value Cthr when the time constant T3 is large. In the graphs indicated in FIG. 7A and FIG. 7B, the vertical axis represents capacitance, and the horizontal axis represents elapsed time. In the graphs, the solid line indicates the capacitance value Cm, the centerline indicates the corrected capacitance value Cm', and the dashed line indicates the threshold value Cthr.

The third parameter P3 is a parameter for eliminating a steep decrease in the capacitance value Cm that occurs in the normal state due to, for example, an open circuit such as from disconnection or chattering of the sensor electrode 21, or fluctuations in the power supply voltage.

As depicted in FIG. 7A and FIG. 7B, if a disconnection or the like occurs, the capacitance value Cm rapidly decreases at the time when the disconnection or the like occurs, and then when the break or the like is resolved, the capacitance value Cm rapidly increases and returns to the original capacitance value Cm.

As depicted in FIG. 7A, when the time constant T3 is set to a relatively large value, the attenuation of the corrected capacitance value Cm' due to the filter processing is reduced (gradual) during the period from when the capacitance value Cm is temporarily decreased due to a disconnection or the like to when the capacitance recovers (the disconnection period). As the corrected capacitance value Cm' attenuates, the threshold value Cthr lowers gradually during the disconnection period. At the point in time when the capacitance value Cm is restored, the capacitance value Cm becomes smaller than the threshold value Cthr, and the hands-on determination result is set to "hands-off". Therefore, even if the capacitance value Cm increases due to the recovery of the disconnection, erroneous detection can be prevented.

On the other hand, as depicted in FIG. 7B, when the time constant T3 is set to a relatively small value, the attenuation of the corrected capacitance value Cm' due to the filter processing increases significantly. As the corrected capacitance value Cm' attenuates, the threshold value Cthr lowers significantly during the disconnection period. At the point in time when the capacitance value Cm is restored, the capacitance value Cm becomes larger than the threshold value Cthr, and the hands-on determination result is set to "hands-on". Therefore, if the capacitance value Cm increases due to the recovery of the disconnection, there is a risk of erroneous detection.

The time constant T3 is a value larger than the time constant T2, and is set to an appropriate value so as to prevent erroneous detection at the point when the capacitance value Cm is restored, in other words, so that the capacitance value Cm at the point when the capacitance value Cm is restored does not exceed the threshold value Cthr. As an example, the time constant T3 can be calculated based on the capacitance value Cm expected under normal circumstances, the capacitance value Cm at which it is determined there is a disconnection (disconnection threshold), and the anticipated length of the disconnection period.

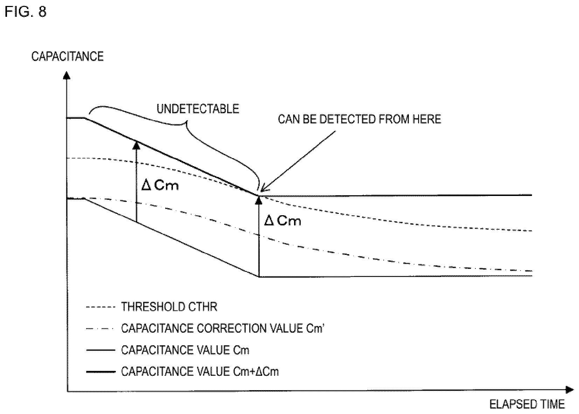

In addition, when a large time constant T3 is set as described above, if the capacitance value Cm is reduced due to an environmental change, a hands-on state may not be detected. FIG. 8 is a diagram describing hands-on detection using a third parameter P3. The vertical axis of the graph depicted in FIG. 8 represents capacitance, and the horizontal axis represents elapsed time. In the graphs, the solid line indicates the capacitance value Cm, the centerline indicates the corrected capacitance value Cm', and the dashed line indicates the threshold value Cthr.

When the capacitance value Cm decreases due to an environmental change, a follow delay occurs in the corrected capacitance value Cm' and the threshold value Cthr, and the corrected capacitance value and the threshold value decrease gradually. When the capacitance value Cm decreases due to an environmental change, the decrease in the capacitance value Cm continues for a longer period of time than in the case of a disconnection, and then the decrease in the capacitance value Cm stops.

Here, as indicated by the thick solid line in the graph, it is assumed that gripping the steering wheel 2 causes the capacitance value Cm to increase by $\Delta Cm$. While the capacitance value Cm is decreasing due to an environmental change, the threshold value Cthr becomes smaller than the capacitance value $Cm+\Delta Cm$, and therefore a hands-off state is set. After the capacitance value Cm stops decreasing, the threshold value Cthr becomes greater than the capacitance value $Cm+\Delta Cm$, and therefore a hands-on state is set.

In this manner, while the capacitance value Cm is decreasing due to environmental changes, there may be cases where grip detection is not performed, but determining this manner of hands-on state to be a hands-off state can be understood to be a decrease in the sensitivity of hands-on detection.

By using the third parameter P3 having the largest time constant T3 when the capacitance value Cm decreases, the steep decrease in the capacitance value Cm can be eliminated and erroneous detection of a hands-on state can be prevented, thereby improving the reliability of the determination.

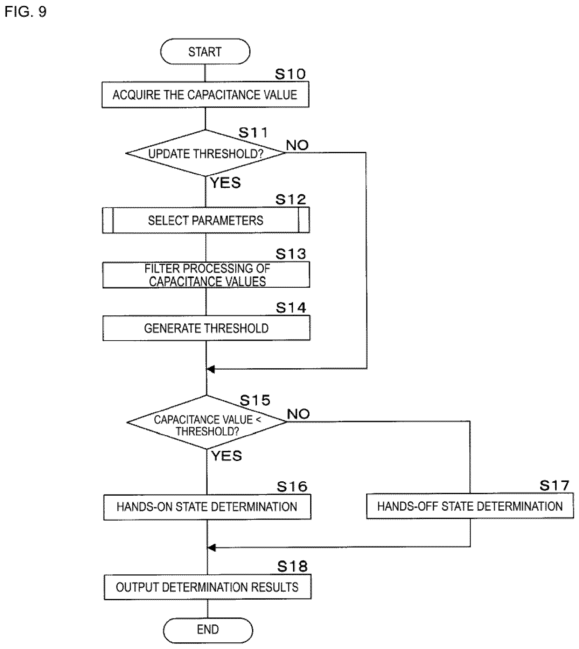

FIG. 9 is a flowchart depicting an example of a processing procedure executed by a hands-on detection ECU 1. The processing in each of the following flowcharts may be executed by the control unit 11 in accordance with the program 121 stored in the storage unit 12 of the hands-on detection ECU 1, or may be achieved by a dedicated hardware circuit (for example, an FPGA or ASIC) provided in the control unit 11, or may be achieved by a combination thereof. After detecting activation of the sensor electrode 21, for example, the control unit 11 of the hands-on detection ECU 1 repeatedly executes the following processing at prescribed or appropriate time intervals.

The control unit 11 of the hands-on detection ECU 1 acquires the capacitance value Cm detected by the sensor electrode 21 (step S10), and stores the acquired capacitance value Cm in the storage unit 12 associated with the time when acquired (elapsed time).

The control unit 11 determines whether or not to update the threshold value Cthr (step S11). The control unit 11 may determine whether or not to update the threshold value Cthr based on the hands-on determination result for the previous capacitance value Cm.

When it is determined that the threshold value Cthr should not be updated because the hands-on determination result is "hands-on state" (step S11: NO), the control unit 11 skips the process of updating the threshold value Cthr and processing advances to step S15. In this case, the control unit 11 may read the threshold value Cthr stored in the storage unit 12.

When it is determined that the threshold value Cthr should be updated because the hands-on determination result is the "hands-off state" (step S11: YES), the control unit 11 selects a parameter P to be used for generating the threshold value Cthr (step S12).

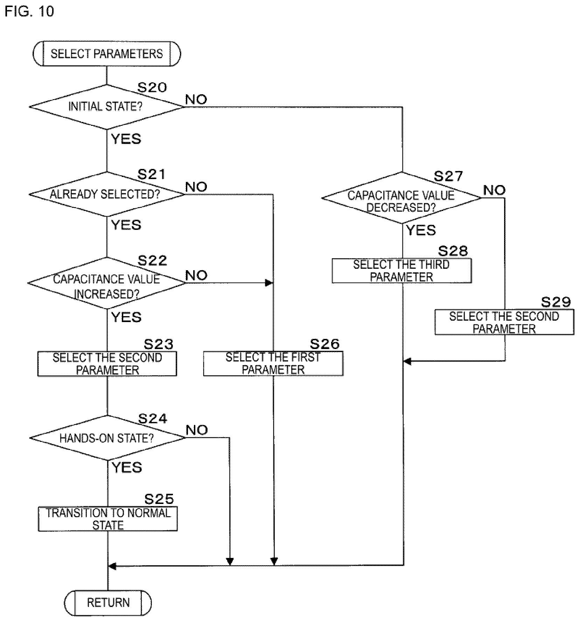

FIG. 10 is a flowchart depicting an example of a detailed procedure for selecting a parameter P. The process procedure indicated in the flowchart of FIG. 10 corresponds to details of step S12 in the flowchart of FIG. 9.

The control unit 11 determines whether the state at the time when the capacitance value Cm is acquired (the present state) is the starting state or not (step S20). Here, not being in a start-up state means that the state has already transitioned to a normal state. In step S20, the control unit 11 may determine whether or not the sensor electrode 21 is in a starting state by determining whether or not an initial hands-on state has been detected, for example, based on the history of determination results stored in the memory unit 12 for after activation of the sensor electrode 21. The control unit 11 may determine whether or not the state is starting state by determining whether or not there is a history of transition to the normal state.

When it is determined that the initial hands-on state has not been detected and thus that the state is the starting state (step S20: YES), the control unit 11 determines whether or not the parameter P has already been selected (step S21).

If it is determined that the parameter P has been selected because the selected parameter P is stored (step S21: YES), the control unit 11 determines whether the capacitance value Cm has increased by comparing the previous capacitance value Cm with the current capacitance value Cm (step S22).

When the capacitance value Cm is determined to be increasing (step S22: YES), the control unit 11 identifies the current state as the second state, and selects the second parameter P2 as the parameter P (step S23). In detail, based on the information stored in the determination data 122 of the storage unit 12, the control unit 11 identifies a second parameter P2 as the parameter P associated with the second state, and stores the identified second parameter P2 in the memory unit 12 as the selected parameter.

The control unit 11 determines whether or not the device is in a hands-on state by referring to the hands-on determination result (step S24). When it is determined that the state is the hands-on state (step S24: YES), the control unit 11 transitions from the start state to the normal state. (Step S25). The control unit 11 stores the transition history in the storage unit 12, and processing returns to step S13 in the flowchart of FIG. 9. Note that the processing in steps S24 and S25 may be performed after the hands-on determination results obtained during the processing of step S13 and subsequent steps in FIG. 9 are acquired.

When the state is determined to not be a hands-on state, in other words, that the state is hands-off state (step S24: NO), the control unit 11 skips the transition process and processing returns to step S13 in the flowchart of FIG. 9.

If it is determined that the parameter P has not been selected because the currently selected parameter P has not been stored (step S21: NO), the control unit 11 selects the first parameter P1 as the initial parameter P (step S26). Alternatively, if it is determined that the capacitance value Cm is not increasing (the capacitance value Cm is constant or decreasing) (step S22: NO), the control unit 11 determines that the current state is the first state and selects the first parameter P1 (step S26). In detail, the control unit 11 identifies a first parameter P1 associated with the first state based on the information stored in the determination data 122 of the storage unit 12, and stores the identified first parameter P1 in the storage unit 12. Thereafter, the control unit 11 returns processing to step S13 in the flowchart of FIG. 9.

When it is determined that the initial hands-on state has already been detected and therefore the state is not the initial state (step S20: NO), the control unit 11 determines whether or not the capacitance value Cm is decreasing (step S27).

If it is determined that the capacitance value Cm is decreasing (step S27: YES), the control unit 11 specifies that the current state is the fourth state, and selects the third parameter P3 (step S28). In detail, the control unit 11 identifies a third parameter P3 associated with the fourth state based on the information stored in the determination data 122 of the storage unit 12, and stores the identified third parameter P3 in the storage unit 12. Thereafter, the control unit 11 returns processing to step S13 in the flowchart of FIG. 9.

On the other hand, if it is determined that the capacitance value Cm is not decreasing (the capacitance value Cm is constant or increasing) (step S27: NO), the control unit 11 determines that the current state is the third state and selects the second parameter P2 (step S29). In detail, the control unit 11 identifies a second parameter P2 associated with the third state based on the information stored in the determination data 122 of the storage unit 12, and stores the identified second parameter P2 in the storage unit 12. Thereafter, the control unit 11 returns processing to step S13 in the flowchart of FIG. 9.

Returning to FIG. 9, the description is continued. The control unit 11 uses the selected parameter P to execute filter processing on the obtained capacitance value Cm (step S13), and outputs a corrected capacitance value Cm' obtained by attenuating the capacitance value Cm.

The control unit 11 generates a threshold value Cthr based on the obtained corrected capacitance value Cm' and the offset value Coff stored in the determination data 122 (step S14). Specifically, the threshold value Cthr is calculated by adding the offset value Coff to the corrected capacitance value Cm'.

The control unit 11 determines whether the acquired current capacitance value Cm is larger or smaller than the generated threshold value Cthr, and whether the current capacitance value Cm is less than the threshold value Cthr (step S15).

If the current capacitance value Cm is determined to be less than the threshold value Cthr (step S15: YES), the control unit 11 determines that the state is hands-off state (step S16). If the current capacitance value Cm is determined to be greater than or equal to the threshold value Cthr (step S15: NO), the control unit 11 determines that the state is a hands-on state (step S17).

The control unit 11 outputs the obtained determination result, for example, to the driver assistance ECU 3 (step S18), and ends the series of processes.

According to the present Embodiment, the parameters used for filter processing can be appropriately switched depending on the state regarding the change in the capacitance value Cm, making it possible to set the threshold value Cthr and achieve hands-on determination; thereby improving hands-on detection accuracy. By performing filter processing using parameters having different time constants depending on the change tendency of the capacitance value Cm, changes in the capacitance value Cm that should be removed can be suitably removed and changes in the capacitance value Cm that should be captured can be suitably followed. Furthermore, by using the parameter having the most responsive time constant immediately after activating the sensor electrode 21, the calibration time immediately after activation can be shortened, improving convenience.

A method for determining the time constants T1 to T3 will be described below with specific numerical examples.

A method for determining the time constant T1 will be described. The parasitic capacitance of the steering wheel 2 is Cp, the offset value is Coff, and the correction capacitance value obtained from the filter processing using the first parameter P1 including the time constant T1 is set as Cm'. Also, the capacitance generated when the driver is gripping the steering wheel 2 at the time of startup is defined as Ch1. After activation, the steering wheel 2 is released temporarily and then gripped again, and here, the capacitance generated is defined as Ch2. The minimum time required to detect hands-on after a temporary hands-off state, that is, the minimum required hands-off period, is defined as Toff. Toff corresponds to the grip release time required to detect re-grasping after grip is released.

The condition for correctly determining hands-on of the steering wheel 2 when the steering wheel is gripped again can be expressed by the following formula (1) using Coff, Cp, Ch2, and Cm'.

$$(Ch2+Cp)>Cthr=Cm'+Coff...(1)$$

Here, Cm' can be expressed by the following formula (2).

$$Cm'=Cp+Ch1\times exp(-Toff/T1)...(2)$$

By solving these two equations for T1, the condition equation for the time constant T1 can be expressed by the following equation (3) using Coff, Ch1, Ch2, and Toff.

$$T1<(-Toff)/ln\{(Ch2-Coff)/Ch1\}...(3)$$

For example, when Cp=50 pF, Coff=10 pF, Ch1=45 pF, Ch2=20 pF, and Toff=500 ms, it is found from the above formulas (1) to (3) that roughly T1 < 332 ms. T1 is set to a value (for example, 80% of the upper limit value) obtained by taking a prescribed margin into account for the upper limit value obtained by equation (3), for example.

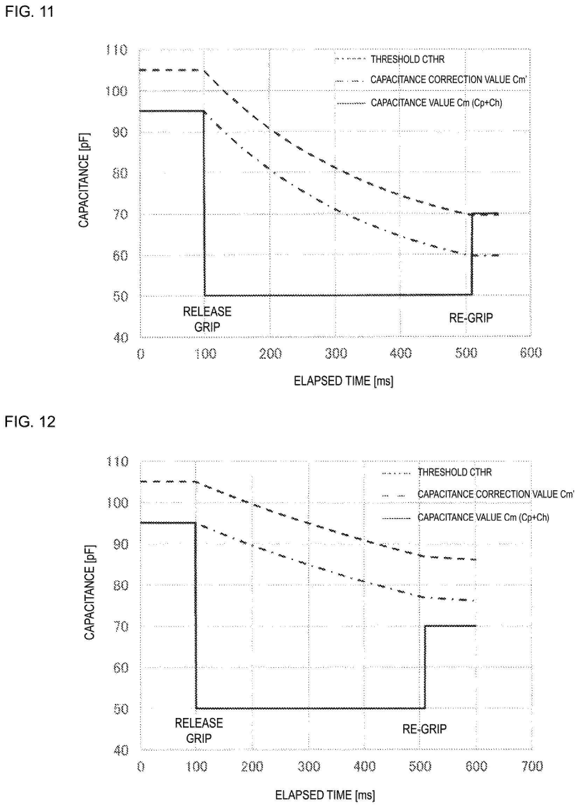

FIG. 11 to FIG. 14 are diagrams depicting examples of hands-on determination when the time constant T1 is changed. In the graphs depicted in the following FIG. 11 to FIG. 20, the vertical axis represents capacitance (in pF), and the horizontal axis represents elapsed time (in ms or s). In FIG. 11 to FIG. 14, the solid line indicates the capacitance value Cm, the centerline indicates the corrected capacitance value Cm', and the dashed line indicates the threshold value Cthr. Cm=Cp+Ch.

The graphs in FIG. 11 to FIG. 13 depict the changes in capacitance value Cm, and the like when the steering wheel device 100 is activated while the driver is already gripping the steering wheel 2, then the driver releases the steering wheel 2 and grips the steering wheel again.

FIG. 11 depicts the changes over time of Cm, Cm', and Cthr when T1=332×0.8=265 ms, Ch1=45 pF, and Ch2=20 pF. As depicted in FIG. 11, when the capacitance value Cm increases due to gripping again, the capacitance value Cm increases above the threshold value Cthr, and therefore the "hands-on" state is correctly determined at the time of re-gripping.

For comparison, FIG. 12 indicates the changes over time of Cm, Cm', and Cthr when T1=265×3=795 ms, Ch1=45 pF, and Ch2=20 pF. As depicted in FIG. 12, if T1 is set to a large value that does not satisfy equation (3), the capacitance value Cm when re-gripping will be smaller than the threshold value Cthr, and the state will be erroneously determined to be "hands-off" at the time of re-gripping.

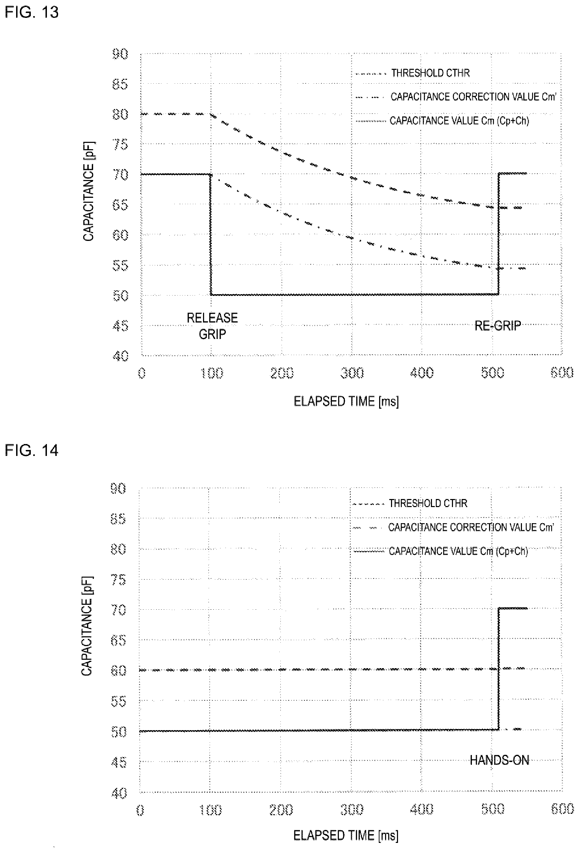

FIG. 13 depicts the changes over time of Cm, Cm', and Cthr when T1=265 ms, Ch1=20 pF, and Ch2=20 pF. As depicted in FIG. 13, even if the capacitance at activation is relatively small, the capacitance value Cm after re-gripping is greater than the threshold value Cthr, and the "hands-on" state is correctly determined when gripped.

FIG. 14 depicts the change in the capacitance value Cm and the like when the steering wheel device 100 is activated in a state where the driver is not gripping the steering wheel 2, and then grips the steering wheel 2 thereafter. FIG. 14 depicts the changes over time of Cm, Cm', and Cthr when T1=265 ms, Ch1=0 pF, and Ch2=20 pF. As depicted in FIG. 14, even if the capacitance value Cm changes from the hands-off state at activation to the hands-on state without any decrease, the capacitance value Cm after gripping becomes larger than the threshold value Cthr, so that the "hands-on" state is correctly determined when gripped.

A method for determining the time constant T2 will be described. The initial value of the parasitic capacitance of the steering wheel 2 (the parasitic capacitance prior to increasing) is Cp, the time required for Cp to increase by 1 pF is Tpp, and the offset value is Coff. Tpp corresponds to the rate of change of the parasitic capacitance Cp.

When the capacitance value Cm is on the rise, if the increase in Cm' is too slow relative to the increase in Cp, the increase in Cthr will also be slow. In this case, even if the state is actually hands-off state, it will be determined to be hands-on state.

When the capacitance value Cm is in an upward trend, the condition equation for Cp to prevent erroneous determination of a hands-off state as a hands-on state can be expressed by the following equation (4) using Cm' and Coff.

$$Cp<Cthr=Cm'+Coff...(4)$$

An appropriate value for T2 can be determined based on a simulation of the time series data of Cp and Cm' obtained by performing filter processing of the time series data using T2. Specifically, the optimum value of T2 that satisfies the above formula (4) is determined by finding the Cp time series change and Cm' and Cthr obtained by a first-order LPF using various T2 values. Tpp for obtaining time series data of Cp is obtained, for example, by experiment.

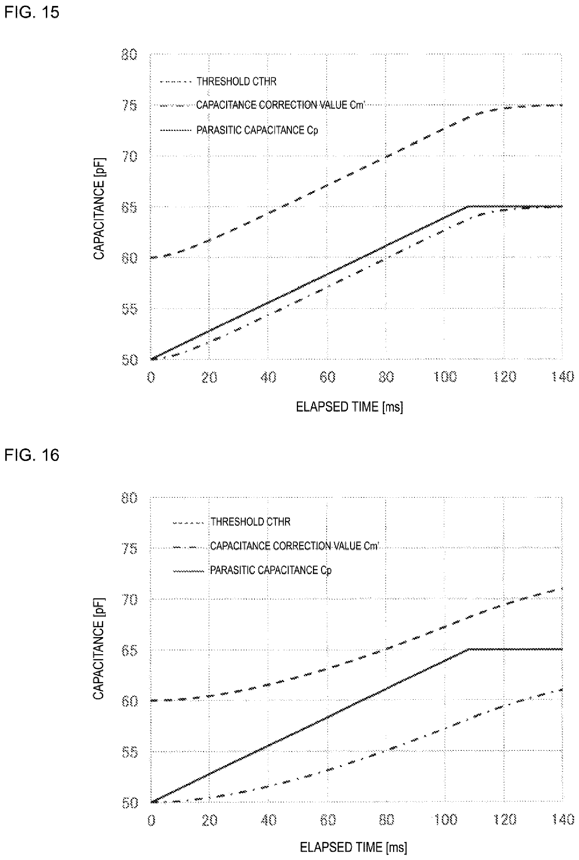

FIG. 15 to FIG. 18 are diagrams depicting examples of hands-on determination when the time constant T2 is changed. The graphs of FIG. 15 to FIG. 18 depict the change in the parasitic capacitance Cp and the like when the parasitic capacitance Cp (capacitance value Cm) has an increasing trend. In FIG. 15 to FIG. 18, the solid line indicates the parasitic capacitance Cp, the centerline indicates the corrected capacitance value Cm', and the dashed line indicates the threshold value Cthr. In FIG. 15 to FIG. 18, the rate of change of Cp, that is, Tpp, was set to 7.2 s, and Cm' was obtained by a first-order LPF using T2. The Tpp value was calculated from the Cp change of 25 pF obtained by actual measurement when changing from 25° C and humidity 30% to 50° C and humidity 80% over 3 minutes.

FIG. 15 depicts the changes in Cp, Cm', and Cthr over time when T2 is set to 10 s. When T2=10 s, after Cp rises, Cthr is significantly larger than Cp, and the "hands-off" state is correctly determined at the time when the parasitic capacitance Cp rises.

FIG. 16 depicts the changes in Cp, Cm', and Cthr over time when T2 is set to 60 s. When T2=60 s, after Cp rises, Cthr is larger than Cp, and the "hands-off" state is correctly determined at the time when the parasitic capacitance Cp rises.

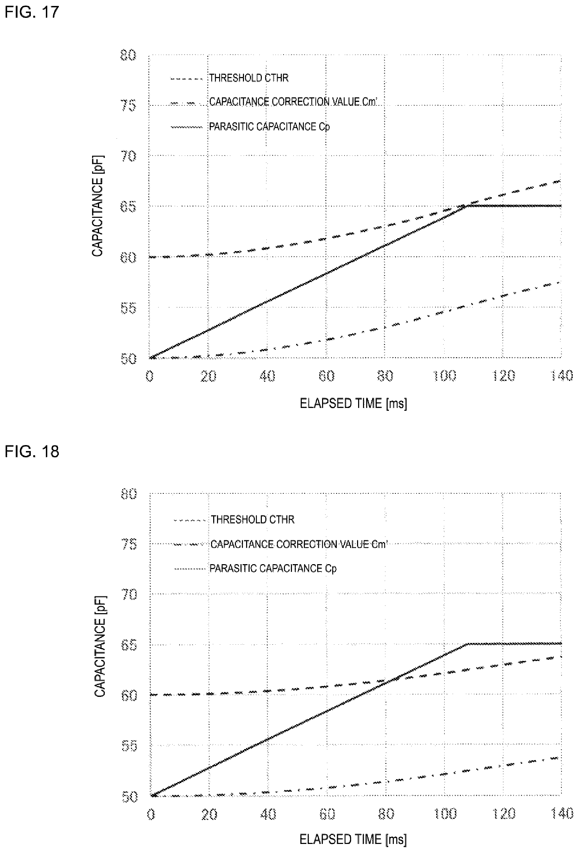

FIG. 17 depicts the changes in Cp, Cm', and Cthr over time when **T2** is set to 120 s. When T2=120 s, after Cp rises, Cthr is slightly larger than Cp, and the "hands-off" state is correctly determined at the time when the parasitic capacitance Cp rises.

FIG. 18 depicts the changes in Cp, Cm', and Cthr over time when **T2 is** set to 300 s. When T2=300 s, Cthr after the increase in Cp is smaller than Cp, and the state is erroneously determined as "hands-on" at the 80 s elapsed point. Setting **T2** too large increases the likelihood of erroneous detection.

A method for determining the time constant T 3 will be described. **The** parasitic capacitance of the steering wheel 2 in a normal state, in other words, when no abnormality such as a disconnection occurs, is defined as Cp1, and the parasitic capacitance that is temporarily reduced due to an abnormality such as a disconnection is set to Cp2. In addition, the period required for the parasitic capacitance to recover after temporarily dropping (disconnection period), that is, the expected duration of the drop in the parasitic capacitance, is set to Tdrop. The correction capacitance value obtained by the filter processing using the third parameter P3 including the time constant T3 is defined as Cm'.

When Cp2 recovers to the original parasitic capacitance Cp1, the condition for Cp1 to correctly determine that the non-gripping state is established can be expressed by the following equation (5) using Cm' and Coff.

$$Cp1 < Cthr = Cm' + Coff ...(5)$$

Here, Cm' at the time Tdrop can be expressed by the following formula (6).

$$Cm' = Cp2 + (Cp1 - Cp2) \times \exp(-Tdrop/T3) ...(6)$$

By solving these two equations for T3, the condition equation for the time constant T3 can be expressed by the following equation (7) using Coff, Cp1, Cp2, and Tdrop.

$$T3 > (-Tdrop)/\ln\{(Cp1 - Cp2 - Coff)/(Cp1 - Cp2)\} ...(7)$$

For example, when Cp1=50 pF, Cp2=30 pF, Coff=10 pF, and Tdrop=60 s, it is found from the above equations (5) to (7) that T3>approximately 87 s. T3 is set to a value (for example, 1.7 times the lower limit value) obtained by taking a prescribed margin into consideration for the lower limit value obtained by equation (7), for example.

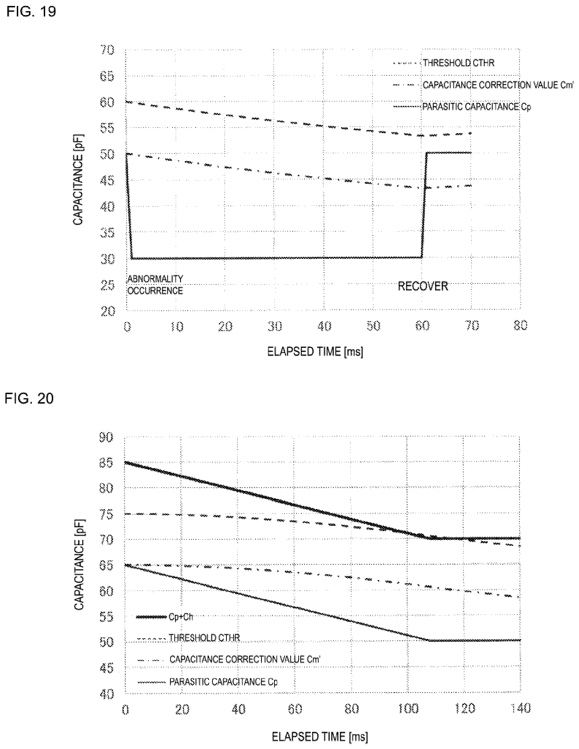

FIG. 19 is a diagram depicting an example of hands-on determination using a time constant T3. The graph in FIG. 19 depicts the change in the parasitic capacitance Cp and the like when the parasitic capacitance decreases due to the occurrence of an abnormality such as a disconnection, and then returns to the original parasitic capacitance after the decrease continues for a certain period of time. FIG. 19 depicts the changes over time of Cp, Cm', and Cthr when T3=87×1.7=147 s, Cp1=50 pF, and Cp2=30 pF. In FIG. 19 and FIG. 20, the thin solid line indicates the parasitic capacitance Cp, the centerline indicates the corrected capacitance value Cm', the dashed line indicates the threshold value Cthr, and the thick solid line indicates Cp+Ch. The thick solid line represents the capacitance value Cm for hands-on of the steering wheel 2.

As depicted in FIG. 19, when the time constant T3 is large, Cp becomes smaller than the threshold value Cthr at the time when the parasitic capacitance returns to its original value due to the abnormality being resolved, so that the "hands-off" state is correctly determined at the time when the parasitic capacitance returns.

FIG. 20 is a diagram depicting another example of hands-on determination using a time constant T3. FIG. 20 depicts the time variations of Cp, Cm', and Cthr when T3=147 s and the parasitic capacitance Cp decreases due to an environmental change. The time required for Cp to decrease by 1 pF due to an environmental change was set to 7.2 s, and the rate of change of Cp was set to 7.2 s/pF.

As depicted in FIG. 20, while the parasitic capacitance Cp is decreasing, the threshold value Cthr decreases gradually as the parasitic capacitance Cp decreases. Even after the decrease in the parasitic capacitance Cp stops, the threshold Cthr continues to decrease for a period of time. In the case that T3=147 s, during the latter period of the decrease in the parasitic capacitance Cp, the threshold value Cthr is greater than Cp+Ch at elapsed times of approximately 100 s to 110 s, and therefore a hands-off state is determined. When the decrease in the parasitic capacitance Cp stops, the threshold value Cthr becomes greater than Cp+Ch, and therefore, the hands-on state is determined to have occurred. As the spacing between Cthr and Cp+Ch becomes narrower, the detection sensitivity of the hands-on state decreases.

The embodiments presently disclosed are to be considered as examples for all points, and are not restrictive. The technical features described in the examples can be combined with each other, and the scope of the invention is intended to include all changes within the scope of the claims and a scope equal to the claims.

The sequences depicted in each embodiment are not limited, and to the extent that there is no inconsistency, each processing procedure may be executed in a different order, and a plurality of processes may be executed in parallel. The main constituent of each process is not limited, and the process of each device may be executed by another device as long as there is no inconsistency.

The features described in each embodiment can be combined with each other. Furthermore, the independent and dependent claims set forth in the claims can be combined with each other in any and all combinations, regardless of the form of reference. Furthermore, the claims are in a format in which a claim refers to two or more other claims (multiple claim format), but the present invention is not limited to this format. A multiple claim (multi-multi claim) may be written using a format that cites at least one multiple claim.

**EXPLANATION OF CODES**

100. Steering wheel device
1. Hands-on detection ECU (hands-on detection device)
11. Control unit
12. Storing part
13. Communication unit
14. Capacitance measurement circuit
111. Acquiring unit
112. Identifying unit
113. Filter unit
114. Generating unit
115. Determination unit
121. Program
1A. Storing media
2. Steering wheel
21. Sensor electrode (capacitance sensor)

**Claims**

1. A hands-on detection device (1) that performs hands-on detection for a steering wheel (2), comprising:

   an acquiring unit (111) that acquires a capacitance value detected by a capacitance sensor (21) provided in the steering wheel; and
   a generating unit (114) that generates a threshold value for performing hands-on detection of the steering wheel (2) based on the capacitance value acquired by the acquiring unit (111) and a parameter corresponding to a state related to change in the capacitance value.

2. The hands-on detection device (1) according to claim 1, wherein the threshold value is generated by performing filter processing using the parameter related to the capacitance value.

3. The hands-on detection device (1) according to claim 1 or claim 2, further comprising:
   an identifying unit (112) that identifies the parameter according to whether or not initial hands-on detection on the steering wheel (2) was achieved after activation of the capacitance sensor (21) and a state related to change of the capacitance value determined based on increase or decrease of the capacitance value.

4. The hands-on detection device (1) according to claim 1 or claim 2, wherein a plurality of parameters are set according to the state of change of the capacitance value.

5. The hands-on detection device (1) according to claim 1 or claim 2, wherein the parameter includes a time constant that represents responsiveness relative to change in the capacitance value.

6. The hands-on detection device (1) according to claim 1 or claim 2, wherein the states related to change in capacitance value include:

   a first state where the capacitance value is constant or decreasing in a period after the capacitance sensor (21) has been activated and initial hands-on of the steering wheel (2) has not been detected,
   a second state where the capacitance value is increasing in a period after the capacitance sensor (21) has been activated and initial hands-on of the steering wheel (2) has not been detected,
   a third state where the capacitance value is constant or increasing in a period after the capacitance sensor (21) has been activated and initial hands-on of the steering wheel (2) has been detected, and

a fourth state where the capacitance value is decreasing in a period after the capacitance sensor (21) has been activated and initial hands-on of the steering wheel (2) has been detected.

7. The hands-on detection device (1) according to claim 6, wherein

the parameters includes a first parameter corresponding to the first state, a second parameter corresponding to the second state and the third state, and a third parameter corresponding to the fourth state,
the first parameter includes a time constant representing the responsiveness related to change in capacitance value,
the second parameter includes a time constant that follows change in the capacitance value with a delay time that is longer than the time constant of the first parameter, and
the third parameter includes a time constant that follows the capacitance value with a delay time that is longer than the time constant of the second parameter.

8. The hands-on detection device (1) according to claim 7, wherein the time constant of the first parameter is determined based on the capacitance value when the steering wheel (2) is gripped, the capacitance value when the steering wheel (2) is re-gripped after grip of the steering wheel (2) is released, and the grip release time necessary to perform detection of re-gripping after grip is released.

9. The hands-on detection device (1) according to claim 7, wherein the time constant of the second parameter is set so that while the capacitance value is increasing, this capacitance value according to a preset rate of change is less than a threshold value generated through filter processing using the second parameter, relative to the capacitance value.

10. The hands-on detection device (1) according to claim 7, wherein the time constant of the third parameter is determined based on the capacitance value for a case where a prescribed abnormality has occurred, the capacitance value prior to the prescribed abnormality occurring, and the time required from occurrence to resolution of the abnormality.

11. The hands-on detection device (1) according to claim 1 or claim 2, wherein the generating unit (114) generates the threshold value and updates the threshold value for the case that hands-on of the steering wheel (2) is not detected.

12. A program (121) in a computer (11) for performing hands-on detection on a steering wheel (2), comprising:

acquiring a capacitance value detected by a capacitance sensor (21) provided on the steering wheel (2); and
executing processing for generating a threshold value to perform hands-on detection on the steering wheel (2) based on the obtained capacitance value and a parameter corresponding to a state related to change in the capacitance value.

FIG. 1

FIG. 2

FIG. 3

FIG. 4

CONTROL UNIT 11

ACQUIRING UNIT 111

IDENTIFYING UNIT 112

FILTER UNIT 113

GENERATING UNIT 114

DETERMINING PART 115

FIG. 5

FIG. 6A

CAPACITANCE

HANDS-ON STATE DETERMINATION

- - - - - THRESHOLD CTHR

— · — CAPACITANCE CORRECTION VALUE Cm'

——— CAPACITANCE VALUE Cm

ELAPSED TIME

FIG. 6B

CAPACITANCE

HANDS-OFF STATE DETERMINATION

- - - - - THRESHOLD CTHR

— · — CAPACITANCE CORRECTION VALUE Cm'

——— CAPACITANCE VALUE Cm

ELAPSED TIME

FIG. 7A

CAPACITANCE

HANDS-OFF STATE IS SET (NO ERRONEOUS DETECTION)

40

20

DISCONNECTION OCCURS

RECOVER

------- THRESHOLD CTHR

— · — · CAPACITANCE CORRECTION VALUE Cm'

——— CAPACITANCE VALUE Cm

ELAPSED TIME

FIG. 7B

CAPACITANCE

HANDS-ON STATE IS SET (ERRONEOUS DETECTION)

40

20

DISCONNECTION OCCURS

RECOVER

------- THRESHOLD CTHR

— · — · CAPACITANCE CORRECTION VALUE Cm'

——— CAPACITANCE VALUE Cm

ELAPSED TIME

FIG. 8

CAPACITANCE

UNDETECTABLE

CAN BE DETECTED FROM HERE

$\Delta$ Cm

$\Delta$ Cm

------ THRESHOLD CTHR

— · — · CAPACITANCE CORRECTION VALUE Cm'

——— CAPACITANCE VALUE Cm

——— CAPACITANCE VALUE Cm+$\Delta$Cm

ELAPSED TIME

FIG. 9

```
                    ( START )
                        │
                      S10
   ┌──────────────────────────────────────┐
   │    ACQUIRE THE CAPACITANCE VALUE      │
   └──────────────────────────────────────┘
                        │
                      S11
              ◇─────────────────◇      NO
              < UPDATE THRESHOLD? >─────────────┐
              ◇─────────────────◇               │
                      │                          │
                     YES                         │
                      │                          │
                    S12                          │
   ┌┃─────────────────────────────────┃┐        │
   │┃        SELECT PARAMETERS         ┃│        │
   └┃─────────────────────────────────┃┘        │
                      │                          │
                    S13                          │
   ┌──────────────────────────────────┐         │
   │       FILTER PROCESSING OF        │         │
   │        CAPACITANCE VALUES         │         │
   └──────────────────────────────────┘         │
                      │                          │
                    S14                          │
   ┌──────────────────────────────────┐         │
   │        GENERATE THRESHOLD         │         │
   └──────────────────────────────────┘         │
                      │                          │
                      ◄──────────────────────────┘
                      │
                    S15
              ◇─────────────────◇      NO
              < CAPACITANCE VALUE < >───────────────────────┐
              <    THRESHOLD?      >                         │
              ◇─────────────────◇                           │
                      │                                      │
                     YES                                     │
                      │                                      │
                    S16                                    S17
   ┌──────────────────────────────┐     ┌────────────────────────────────┐
   │  HANDS-ON STATE DETERMINATION │     │  HANDS-OFF STATE DETERMINATION │
   └──────────────────────────────┘     └────────────────────────────────┘
                      │                                      │
                      ◄──────────────────────────────────────┘
                      │
                    S18
   ┌──────────────────────────────────┐
   │    OUTPUT DETERMINATION RESULTS   │
   └──────────────────────────────────┘
                      │
                    ( END )
```

FIG. 10

```
                    ( SELECT PARAMETERS )
                               |
                         S20   |
                  ┌────────────────────┐    NO
                  <    INITIAL STATE?    >──────────────────────────────────┐
                  └────────────────────┘                                    |
                            │ YES                                           |
                            │                                               |
                    S21     │                                    S27        |
            ┌────────────────────┐   NO              ┌────────────────────┐ |   NO
            <  ALREADY SELECTED?  >───────┐          < CAPACITANCE VALUE   >─────────┐
            └────────────────────┘        |          <    DECREASED?       > |       |
                      │ YES               |          └────────────────────┘ |       |
                      │                   |                    │ YES         |       |
              S22     │                   |          ┌──────────────────────┐|       |
        ┌────────────────────┐   NO       |          │ SELECT THE THIRD S28 ││       |
        < CAPACITANCE VALUE   >───────────┤          │     PARAMETER        ││       |
        <    INCREASED?       >           |          └──────────────────────┘|       |
        └────────────────────┘           |                    |             |   S29 |
                  │ YES                   |          ┌──────────────────────────────┐|
                  │                       |          │  SELECT THE SECOND           │|
        ┌──────────────────┐  S23  ┌──────────────┐  │      PARAMETER               │|
        │ SELECT THE SECOND│       │ SELECT THE   │  └──────────────────────────────┘
        │    PARAMETER     │       │ FIRST S26    │                │
        └──────────────────┘       │ PARAMETER    │                │
                  │                 └──────────────┘                │
          S24     │                        │                        │
        ┌──────────────────┐   NO          │                        │
        <  HANDS-ON STATE?  >────────┐     │                        │
        └──────────────────┘         |     │                        │
                  │ YES              |     │                        │
                  │                  |     │                        │
        ┌──────────────────┐  S25    |     │                        │
        │ TRANSITION TO     │        |     │                        │
        │ NORMAL STATE      │        |     │                        │
        └──────────────────┘        |     │                        │
                  │◄────────────────┴─────┴────────────────────────┘
                  │
             (  RETURN  )
```

FIG. 11

FIG. 12

FIG. 13

FIG. 14

FIG. 15

FIG. 16

FIG. 17

FIG. 18

FIG. 19

FIG. 20

| | INTERNATIONAL SEARCH REPORT | International application No. |
|---|---|---|
| | | **PCT/JP2023/015106** |

**A. CLASSIFICATION OF SUBJECT MATTER**

***B62D 1/06***(2006.01)i; ***B62D 6/00***(2006.01)i; ***H01H 36/00***(2006.01)i
FI:  B62D1/06; B62D6/00; H01H36/00 J

According to International Patent Classification (IPC) or to both national classification and IPC

**B. FIELDS SEARCHED**

Minimum documentation searched (classification system followed by classification symbols)

B62D1/00; B62D6/00; H01H36/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2018-47816 A (TOYOTA MOTOR CORP) 29 March 2018 (2018-03-29) paragraphs [0040]-[0110], fig. 1-4 | 1, 3-4, 11-12 |
| A | JP 2017-87883 A (HONDA MOTOR CO LTD) 25 May 2017 (2017-05-25) | 1-12 |
| A | JP 2016-217725 A (TOKAI RIKA CO LTD) 22 December 2016 (2016-12-22) | 1-12 |
| A | JP 2020-085536 A (TOKAI RIKA CO LTD) 04 June 2020 (2020-06-04) | 1-12 |
| A | JP 2019-211839 A (TOKAI RIKA CO LTD) 12 December 2019 (2019-12-12) | 1-12 |
| A | JP 2018-069935 A (HONDA MOTOR CO LTD) 10 May 2018 (2018-05-10) | 1-12 |

☐ Further documents are listed in the continuation of Box C.     ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **12 May 2023** | **23 May 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**
Information on patent family members

International application No.

**PCT/JP2023/015106**

| Patent document cited in search report | | | Publication date (day/month/year) | Patent family member(s) | | | Publication date (day/month/year) |
|---|---|---|---|---|---|---|---|
| JP | 2018-47816 | A | 29 March 2018 | US paragraphs [0062]-[0134], fig. 1-4 | 2018/0087929 | A1 | |
| JP | 2017-87883 | A | 25 May 2017 | US | 2017/0129499 | A1 | |
| | | | | CN | 106985907 | A | |
| JP | 2016-217725 | A | 22 December 2016 | US | 2018/0152185 | A1 | |
| | | | | WO | 2016/182014 | A1 | |
| | | | | CN | 107615096 | A | |
| JP | 2020-085536 | A | 04 June 2020 | (Family: none) | | | |
| JP | 2019-211839 | A | 12 December 2019 | (Family: none) | | | |
| JP | 2018-069935 | A | 10 May 2018 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019023012 A